Europäisches Patentamt

European Patent Office

Office européen des brevets

(11) Veröffentlichungsnummer: **0 217 176**
**A2**

(12) # EUROPÄISCHE PATENTANMELDUNG

(21) Anmeldenummer: **86112369.3**

(22) Anmeldetag: **06.09.86**

(51) Int. Cl.⁴: **H 01 L 23/14**
**H 01 L 23/36**

(30) Priorität: **02.10.85 DE 3535081**

(43) Veröffentlichungstag der Anmeldung:
**08.04.87 Patentblatt 87/15**

(84) Benannte Vertragsstaaten:
**DE FR GB NL**

(71) Anmelder: **VACUUMSCHMELZE GMBH**
**Grüner Weg 37 Postfach 2253**
**D-6450 Hanau 1(DE)**

(72) Erfinder: **Dolezal, Norbert, Dipl.-Phys.**
**Saalburgstrasse 8**
**D-6369 Nidderau(DE)**

(72) Erfinder: **Hausch, Gernot, Dr.**
**Leipziger Strasse 45**
**D-6456 Langenselbold(DE)**

(72) Erfinder: **Reppel, Georg-Werner, Dipl.-Phys.**
**Goldbergstrasse 4**
**D-6451 Hammersbach(DE)**

(54) **Verbundwerkstoff und Verfahren zu seiner Herstellung.**

(57) Insbesondere zur Verbesserung der Anpassung des Wärmeausdehnungskoeffizienten von Substratmaterial für Leistungshalbleiter an das Wärmeausdehnungsverhalten von Silizium weist ein Verbundwerkstoff aus metallischen und nichtmetallischen Komponenten zwischen 20 und 80 Volumenprozent Kupfer und/oder Molybdän und als Rest mindestens eine nichtmetallische Komponente auf. Als nichtmetallische Komponente haben sich Borosilikatglas, alkalifreies Hartglas, Quarzglas und β-Eukryptit als besonders geeignet erwiesen.

Die Herstellung des Verbundwerkstoffs kann vorteilhaft auf pulvermetallurgischem Wege erfolgen. Eine Nachverformung der gesinterten Preßkörper vorzugsweise mittels Strangpressen führt zu einem anisotropen Ausdehnungsverhalten und zu einer Anisotropie der elektrischen und thermischen Leitfähigkeit des Verbundwerkstoffs.

Vacuumschmelze GmbH

Hanau

## Verbundwerkstoff und Verfahren zu seiner Herstellung

Die Erfindung betrifft einen Verbundwerkstoff aus metallischen und nichtmetallischen Komponenten, insbesondere als Substratmaterial für Leistungshalbleiter mit einem an Silizium angepaßten Wärmeausdehnungskoeffizienten sowie ein Verfahren zur Herstellung eines derartigen Verbundwerkstoffs.

Halbleiteranordnungen für große Stromstärken enthalten üblicherweise eine Scheibe aus halbleitendem Material, z. B. Silizium, das ein- oder beidseitig direkt oder über Lotgrenzflächen in Kontakt zu anderen Materialien steht. Hierbei ist es wesentlich, daß die unmittelbar angrenzenden Materialien in ihrem Wärmeausdehnungsverhalten zueinander angepaßt sind, gleichzeitig aber auch eine elektrische Verbindung mit geringem Widerstand ermöglichen.

Es ist bereits bekannt, bei Verbindungen mit wärmeableitenden Elementen beispielsweise aus Kupfer, Aluminium oder Silber mit Halbleitermaterial Zwischenschichten aus Materialien mit geringem thermischen Ausdehnungskoeffizienten, wie z. B. Molybdän oder Wolfram in Form von Platten oder Zylindern vorzusehen. Durch diese Zwischenschicht soll die Halbleiterscheibe gegen von den Anschlußkörpern herrührenden mechanischen Beanspruchungen geschützt werden, die während wechselnder Temperaturänderung auftreten können.

30.09.1985
G-VP-Ge/Ha

Obwohl dünne Platten aus Molybdän oder Wolfram für einen ausreichenden Transport der in der Halbleiterscheibe entstehenden Wärme sorgen und aufgrund des verhältnismäßig geringen Wärmeausdehnungskoeffizienten sich auch gut als Zwischenkörper eignen, werden seit längerer Zeit erhebliche Anstrengungen unternommen, Materialien zu entwickeln, die preiswerter als Molybdän oder Wolfram und insbesondere in ihrem thermischen Ausdehnungskoeffizienten noch besser an den des Siliziums angepaßt sind.

Der Erfindung liegt daher die Aufgabe zugrunde, einen Werkstoff als Substratmaterial für Leistungshalbleiter bereitzustellen, der vorzugsweise den niedrigen Wärmeausdehnungskoeffizienten des Siliziums aufweist. Ferner liegt der Erfindung die Aufgabe zugrunde, ein Verfahren zur Herstellung eines derartigen Werkstoffs anzugeben.

Zur Lösung der zuerst genannten Aufgabe wird ein Verbundwerkstoff vorgeschlagen, der erfindungsgemäß aus 20 bis 80 Volumenprozent Kupfer und/oder Molybdän und mindestens einer nichtmetallischen Komponente zusammengesetzt ist, wobei die nichtmetallische Komponente einen gegenüber der metallischen Komponente niedrigeren Wärmeausdehnungskoeffizienten aufweist.
Vorteilhafte Ausgestaltungen des Verbundwerkstoffs sind in den Unteransprüchen genannt.

Ein Verfahren zur Herstellung eines aus metallischen und nichtmetallischen Komponenten zusammengesetzten Verbundwerkstoffs nach der Erfindung ist durch die in Anspruch 6 genannten Merkmale gekennzeichnet. Vorteilhafte Weiterbildungen des Verfahrens ergeben sich aus den Merkmalen der Ansprüche 7 bis 10.

Durch Kombination einer oder mehrerer metallischer Komponenten mit guter thermischer und elektrischer Leitfähigkeit (Kupfer und/ oder Molybdän) mit einer oder mehreren Komponenten mit niedrigem bzw. vorzugsweise negativem Wärmeausdehnungskoeffizienten (Hartglas und/oder keramisches Material) lassen sich Verbundwerkstoffe herstellen, die innerhalb eines vorgegebenen Temperaturbereichs etwa zwischen Raumtemperatur und 400°C nahezu optimal an das thermische Ausdehnungsverhalten von Silizium angepaßt sind und zusätzlich günstige elektrische und/oder thermische Leitfähigkeitseigenschaften aufweisen. Der jeweilige Kupfer- und /oder Molybdänanteil in diesem Verbundmaterial beeinflußt dabei insbesondere das Verhalten der elektrischen und thermischen Leitfähigkeit, während mit dem keramischen bzw. Hartglas-Material der gewünschte thermische Ausdehnungskoeffizient eingestellt werden kann.

Ein besonders vorteilhaftes Ausdehnungsverhalten läßt sich in den Verbundsystemen Molybdän-Keramik, Kupfer-Molybdän-Keramik, Kupfer-Hartglas-Keramik sowie in dem aus vier Komponenten bestehenden System Kupfer-Molybdän-Hartglas-Keramik innerhalb bestimmter Zusammensetzungsgrenzen erreichen.

Als nichtmetallische Komponenten eignen sich insbesondere Hartgläser, z. B. Borosilikatglas, alkalifreies Hartglas oder Quarzglas. Wegen ihres günstigen Wärmeausdehnungsverhaltens können vorzugsweise auch keramische Materialien verwendet werden, z. B. Lithium-Aluminiumsilikat (ß-Eukryptit), Aluminiumoxid ($Al_2O_3$), Siliziumcarbid (SiC) oder Aluminiumnitrid (AlN). Sowohl Hartglas als auch keramische Werkstoffe weisen verhältnismäßig hohe Erweichungstemperaturen und einen niedrigen Wärmeausdehnungskoeffizienten auf. So beträgt z. B. der Wärmeausdehnungskoeffizient von Borosilikatglas im Temperaturbereich von -80 bis zu 400°C etwa $3 \cdot 10^{-6} \ K^{-1}$, während ß-Eukryptit mit $-6$ bis $-9 \cdot 10^{-6} \ K^{-1}$ einen stark negativen Wärmeausdehnungskoeffizienten aufweist.

Anhand von einigen Ausführungsbeispielen und einer Figur soll die Erfindung nachstehend noch näher erläutert werden.

## Beispiele 1 bis 15

Zur Herstellung von Pulververbundwerkstoffen aus den elektrisch leitenden Komponenten Kupfer und/oder Molybdän und einer nichtmetallischen Komponente wurden feinkörnige Pulver mit einer mittleren Korngröße zwischen 0,1 und 40 $\mu$m in unterschiedlichen Volumenprozenten gemischt und dann kaltisostatisch oder im Werkzeug gepreßt. Die Zusammensetzung der untersuchten Pulververbundwerkstoffe ist in Tabelle I in Volumenprozent angegeben. Für die Ausführungsbeispiele 1 bis 13 wurde als Hartglaskomponente ein Borsilikatglas verwendet, das im Handel unter der Bezeichnung Duran 50 bzw. 8330 erhältlich ist, für die Ausführungsbeispiele 14 und 15 ein alkalifreies Hartglas mit der Bezeichnung 8252. Als keramisches Material fand ausschließlich ß-Eukryptit Verwendung.

Die Preßkörper wurden bei 1050°C, also unterhalb der Schmelztemperatur von Kupfer, in reinem Wasserstoff gesintert, wobei die Sinterzeit jeweils mindestens 1 Stunde betrug. Zur weiteren Verringerung der Restporosität wurden die Sinterkörper entweder heißisostatisch gepreßt oder gleichzeitig mit einer Verformung stranggepreßt und/oder gewalzt. Besonders günstig ist es, einen verdichteten Pulverkörper in ein Rohr aus Kupfer oder einer Kupferlegierung bzw. in ein Stahlrohr, z. B. aus Stahl der Gütegruppe St 37 einzusetzen. Die Rohrenden wurden vakuumdicht zugeschweißt und die gekapselten Sinterbolzen dann heißgewalzt oder stranggepreßt. Die Weiterbearbeitung zu Ronden erfolgte dann üblicherweise, z. B. durch Absägen von der Stange.

**Tabelle I**

| Beispiel Nr. | Kupfer | Molybdän | Hartglas | Keramik |
|---|---|---|---|---|
| 1 | 20 | - | 50 | 30 |
| 2 | 30 | - | 50 | 20 |
| 3 | 30 | - | 35 | 35 |
| 4 | 40 | - | 30 | 30 |
| 5 | 70 | - | 25 | 5 |
| 6 | 30 | - | 40 | 30 |
| 7 | 50 | - | 50 | - |
| 8 | 50 | - | - | 50 |
| 9 | - | 70 | - | 30 |
| 10 | 10 | 45 | - | 45 |
| 11 | 20 | 40 | - | 40 |
| 12 | 40 | 40 | - | 20 |
| 13 | 30 | 40 | - | 30 |
| 14 | 30 | - | 50 | 20 |
| 15 | 30 | - | 35 | 35 |

Das stranggepreßte Material kann ebenfalls zu dünneren Abmessungen gezogen werden bzw. zu Draht verarbeitet werden. Die gemeinsame Verformung des Pulververbundwerkstoffes in einem Hüllrohr hat sich als fertigungstechnisch besonders geeignetes Verfahren erwiesen. Falls für die weitere Verarbeitung das verbleibende Hüllmaterial störend ist, kann dieses abgefräst bzw. abgezogen werden. Weitere Feinverarbeitungsschritte, wie Schleifen und galvanische Beschichtung mit Nickel, Silber oder anderen geeigneten Materialien können sich in bekannter Weise anschließen.

An feingeschliffenen Ronden wurden die in Tabelle II angegebenen Kennwerte für den Wärmeausdehnungskoeffizienten $\alpha$ bezogen auf die Temperaturbereiche von Raumtemperatur bis 100°C bzw. 400°C und für den spezifischen elektrischen Widerstand $\varrho$ bei Raumtemperatur gemessen.

Tabelle II

| Beispiel Nr. | $\varsigma$ $(\mu\Omega\,cm)$ | $\alpha$ ($10^{-6}$ $K^{-1}$) (20-100°C) | (20-400°C) |
|---|---|---|---|
| 1 | 120 | 2,1 | 2,5 |
| 2 | 14 | 3,0 | 3,7 |
| 3 | 16 | 5,6 | 4,7 |
| 4 | 15 | 7,1 | 6,2 |
| 5 | | 14 | 16,4 |
| 6 | 12,5 | 5,3 | 7,0 |
| 7 | | 14,4 | 17,9 |
| 8 | 11 | 8 | 3,7 |
| 9 | | 3,6 | 3,3 |
| 10 | 10 | 3,2 | 3,3 |
| 11 | 12 | 4,4 | 4,3 |
| 12 | 4,8 | 8,1 | 7,2 |
| 13 | 5,9 | 8,0 | 7,6 |
| 14 | 48 | 3,8 | 3,9 |
| 15 | 67 | 2,15 | 2,4 |

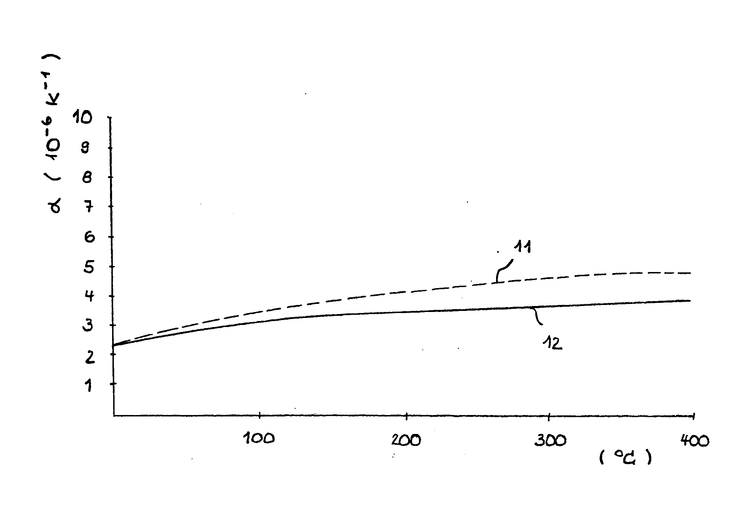

Die Meßergebnisse zeigen, daß die Zusammensetzung mit 30 Volumenprozent Kupfer, 50 Volumenprozent Borosilikatglas und 20 Volumenprozent ß-Eukryptit (Beispiel 2) insgesamt das günstigste Eigenschaftsprofil hinsichtlich der Kennwerte für den Wärmeausdehnungskoeffizienten und den spezifischen elektrischen Widerstand besitzt. Der Wärmeausdehnungskoeffizient beträgt im Temperaturbereich von 20 bis 100°C 3,0 · $10^{-6}$ $K^{-1}$ und im Temperaturbereich von 20 bis 400°C 3,7 · $10^{-6}$ $K^{-1}$ . Der Verlauf des linearen Wärmeausdehnungskoeffizienten $\alpha$ in Abhängigkeit von der Temperatur für den Pulververbundwerkstoff des Ausführungsbeispiels 2 (Kurve 11) und für Silizium (Kurve 12) sind in der Figur dargestellt. Man erkennt deutlich die weitgehende Übereinstimmung dieser beiden Werkstoffe in ihrem Ausdehnungsverhalten über den gesamten Temperaturbereich von 0 bis 400°C.

Der spezifische elektrische Widerstand für den Pulververbundwerkstoff des Beispiels 2 ist zwar mit 14 $\mu\Omega$cm größer als der
für Reinmolybdän, jedoch für die vorgesehene technische Anwendung
noch tragbar.

Die relativ hohen Werte für den spezifischen elektrischen Widerstand bei den Ausführungsbeispielen 14 und 15 sind durch eine zu
geringe Dichte des gesinterten Verbundkörpers bedingt. Da der
spezifische elektrische Widerstand im wesentlichen von der Restporosität des Sinterkörpers abhängt, kann die Restporosität
und damit auch der Kennwert für $\varsigma$ z. B. durch eine heißisostatische Nachverdichtung noch erniedrigt werden.
Überraschenderweise hat sich ferner gezeigt, daß der Wärmeausdehnungskoeffizient bei Verwendung von alkalifreiem Hartglas
(Ausführungsbeispiele 14 und 15) unterhalb einer Temperatur von
700°C kleiner als $5 \cdot 10^{-6}$ $K^{-1}$ bleibt.

<u>Beispiele 16 bis 22</u>

Für die folgenden Beispiele wurden verschiedene Pulvermischungen
aus den vier Komponenten Kupfer, Molybdän, Borosilikatglas und
ß-Eukryptit hergestellt. Die Zusammensetzung der untersuchten
Pulververbundwerkstoffe ist Tabelle III zu entnehmen.

<u>Tabelle III</u>

| Beispiel Nr. | Kupfer | Molybdän | Hartglas | Keramik |
|---|---|---|---|---|
| 16 | 25 | 25 | 30 | 20 |
| 17 | 20 | 10 | 50 | 20 |
| 18 | 20 | 10 | 35 | 35 |
| 19 | 25 | 25 | 20 | 30 |
| 20 | 25 | 25 | 20 | 30 |
| 21 | 15 | 25 | 25 | 35 |
| 22 | 15 | 25 | 25 | 35 |

Die Pulvermischungen wurden zunächst kaltisostatisch gepreßt und bei 950°C unter Wasserstoff gesintert. Ein Teil der Sinterbolzen (Ausführungsbeispiele 19 und 21) wurde in ein Rohr aus einer niedriglegierten Stahllegierung eingekapselt, vakuumdicht verschlossen und dann mit einem Gesamtverformungsgrad von 84 % stranggepreßt. Wesentlich ist auch hier, daß beim Strangpressen die Schmelztemperatur des Kupfers keinesfalls überschritten werden darf. An rondenförmigen planparallel geschliffenen Proben wurde der Wärmeausdehnungskoeffizient senkrecht ($\alpha_{senkrecht}$) und parallel ($\alpha_{parallel}$) zur Strangpreßrichtung bestimmt. Bei einigen Proben wurde ergänzend der spezifische elektrische Widerstand gemessen. Sämtliche Meßergebnisse sind in Tabelle IV zusammengefaßt.

Tabelle IV

| Beispiel Nr. | $\varrho$ ($\mu\Omega$ cm) | $\alpha_{\perp}$ $(10^{-6}K^{-1})$ | $\alpha_{\parallel}$ $(10^{-6}K^{-1})$ |
|---|---|---|---|
| | | ( 20 - 400°C ) | |
| 16 | 33 | 6,1 | 6,1 (isotrop) |
| 17 | 43 | 6,1 | 6,1 (isotrop) |
| 18 | | 3,2 | 3,2 (isotrop) |
| 19 | 7,1 | 5,56 | 6,81 |
| 20 | | 4,64 | 4,64 (isotrop) |
| 21 | 20,4 | 4,4 | 4,5 |
| 22 | | 3,0 | 3,0 (isotrop) |

Aufgrund der Meßergebnisse bei den Ausführungsbeispielen 19 und 21 zeigte sich, daß der Wärmeausdehnungskoeffizient durch das Strangpressen einen gegenüber den gesinterten Proben (isotropes Ausdehnungsverhalten) leicht erhöhten, aber immer noch zulässigen Wert annehmen kann. Wie weitere Untersuchungen ergaben, ist dieser Effekt um so stärker ausgeprägt, je weiter man sich von einer isotropen Anordnung der Pulverkerne in Richtung auf eine Fasertextur entfernt.

**0217176**

Die nach dem erfindungsgemäßen Verfahren hergestellten Verbundwerkstoffe verfügen nicht nur über eine außergewöhnlich gute Anpassung an das Wärmeausdehnungsverhalten von Silizium, sondern weisen auch zumindest gegenüber den bisher im wesentlichen verwendeten Substratmaterialien Molybdän bzw. Wolfram, die nahe $2000^{o}$C bzw. oberhalb $2500^{o}$C gesintert werden müssen, verfahrenstechnische Vorteile auf.

## Patentansprüche

1. Verbundwerkstoff aus metallischen und nichtmetallischen Komponenten, insbesondere als Substratmaterial für Leistungshalbleiter mit einem an Silizium angepaßten Wärmeausdehnungskoeffizienten, g e k e n n z e i c h n e t   d u r c h   eine Zusammensetzung, die als metallische Komponente Kupfer und/oder Molybdän mit einem Gehalt zwischen 20 und 80 Volumenprozent und als Rest mindestens eine nichtmetallische Komponente mit gegenüber der metallischen Komponente niedrigerem Wärmeausdehnungskoeffizienten enthält.

2. Verbundwerkstoff nach Anspruch 1, g e k e n n z e i c h n e t   d u r c h   die Zusammensetzung $Cu_a G_c K_d$, wobei Cu Kupfer, G ein Hartglasmaterial und K ein keramisches Material bedeuten, a im Bereich von 20 bis 60 Volumenprozent, c im Bereich von 0 bis 50 Volumenprozent und d im Bereich von 10 bis 50 Volumenprozent liegen und a + b + c   100 Volumenprozent ergibt.

3. Verbundwerkstoff nach Anspruch 1, g e k e n n z e i c h n e t   d u r c h   die Zusammensetzung $Cu_a Mo_b G_c K_d$, wobei Cu Kupfer, Mo Molybdän, G ein Hartglasmaterial und K ein keramisches Material bedeuten, a im Bereich von 15 bis 40 Volumenprozent, b im Bereich von 10 bis 50 Volumenprozent, c im Bereich von 0 bis 50 Volumenprozent und e im Bereich von 20 bis 50 Volumenprozent liegen und a + b + c + d   100 Volumenprozent ergibt.

4. Verbundwerkstoff nach einem der Ansprüche 1 bis 3, dadurch g e k e n n z e i c h n e t , daß das Hartglasmaterial einen Wärmeausdehnungskoeffizienten unterhalb etwa $5 \cdot 10^{-6} \ K^{-1}$ aufweist.

5. Verbundwerkstoff nach einem der Ansprüche 1 bis 3, d a d u r c h   g e k e n n z e i c h n e t , daß das keramische Material einen negativen Wärmeausdehnungskoeffizienten im Bereich von 6 bis $9 \cdot 10^{-6} \ K^{-1}$ aufweist.

6. Verfahren zur Herstellung eines Verbundwerkstoffs nach einem der Ansprüche 1 bis 5, g e k e n n z e i c h n e t   d u r c h folgende Verfahrensschritte:

a) Mischen von Metallpulver mit den nichtmetallischen Pulverkomponenten

b) Verdichten des Pulvergemisches zu einem Preßkörper

c) Sintern des Preßkörpers bei einer Temperatur unterhalb des Schmelzpunktes von Kupfer.

7. Verfahren zur Herstellung eines Verbundwerkstoffs nach Anspruch 6, d a d u r c h   g e k e n n z e i c h n e t , daß die mittlere Teilchengröße der verwendeten Pulver zwischen 0,1 und 40 $\mu$m liegt.

8. Verfahren nach Anspruch 6 oder 7, d a d u r c h   g e k e n n z e i c h n e t , daß der Preßkörper bei einer Temperatur von etwa 900°C bis 1050°C unter Schutzgasatmosphäre gesintert wird.

9. Verfahren nach Anspruch 8, d a d u r c h   g e k e n n z e i c h n e t , daß der Verbundwerkstoff nach dem Sintern heißisostatisch nachverdichtet wird.

10. Verfahren nach einem der Ansprüche 6 bis 8, d a d u r c h g e k e n n z e i c h n e t , daß der Verbundwerkstoff nach dem Sintern stranggepreßt wird.

11. Verwendung eines nach Anspruch 10 hergestellten Verbundwerkstoffs mit anisotropem Wärmeausdehnungskoeffizienten als Substratmaterial für Leistungshalbleiter.

0217176

VP 85 P 9561